# EUROPEAN PATENT APPLICATION

(11) **EP 4 261 324 A1**
(43) Date of publication of application: **18.10.2023**
(21) Application number: 23162371.1
(22) Date of filing: 16.03.2023
(51) Int. Cl.: C23C 16/34, C23C 16/455, C23C 16/56

(54) **METHOD OF PROCESSING SUBSTRATE, METHOD OF MANUFACTURING SEMICONDUCTOR DEVICE, PROGRAM, AND SUBSTRATE PROCESSING APPARATUS**

(30) Priority: 18.03.2022 JP 2022044289
(71) Applicant: Kokusai Electric Corp., Tokyo 1010045 (JP)
(72) Inventor: SEINO, Atsuro, Toyama, 9392393 (JP); OGAWA, Arito, Toyama, 9392393 (JP)
(74) Representative: Bardehle Pagenberg Partnerschaft mbB Patentanwälte Rechtsanwälte

(57) **Abstract**

Included are: (a) supplying a first processing gas containing a first element and a halogen to a substrate (200); (b) supplying a second processing gas including a N-N bond and a N-H bond to the substrate (200); and (c) performing (a) and (b) X times, X being a natural number, in a state where the substrate is heated to a temperature of 250 degrees C or lower to form a first film containing the first element.

## Description

### CROSS-REFERENCE TO RELATED APPLICATION

This application is based upon and claims the benefit of priority from Japanese Patent Application No. 2022-044289, filed on March 18, 2022, the entire contents of which are incorporated herein by reference.

### TECHNICAL FIELD

The present disclosure relates to a method of processing a substrate, a method of manufacturing a semiconductor device, a program, and a substrate processing apparatus.

### BACKGROUND

For example, a low-resistance metal film is used as a word line of a 3D NAND flash memory or a DRAM having a three-dimensional structure. In addition, a barrier film may be formed between the metal film and an insulating film.

### SUMMARY

According to embodiments of the present disclosure, there is provided a technique including: (a) supplying a first processing gas containing a first element and a halogen to a substrate; (b) supplying a second processing gas including a N-N bond and a N-H bond to the substrate; and (c) performing (a) and (b) X times, X being a natural number, in a state where the substrate is heated to a temperature of 250 degrees C or lower to form a first film containing the first element.

### BRIEF DESCRIPTION OF DRAWINGS

The accompanying drawings, which are incorporated in and constitute a part of the specification, illustrate embodiments of the present disclosure.
FIG. 1 is a vertical cross-sectional view schematically illustrating a vertical processing furnace of a substrate processing apparatus in embodiments of the present disclosure.
FIG. 2 is a schematic horizontal cross-sectional view taken along line A-A in FIG. 1.
FIG. 3 is a schematic configuration diagram of a controller of the substrate processing apparatus in embodiments of the present disclosure, and is a block diagram illustrating a control system of the controller.
FIG. 4 is a diagram illustrating a substrate processing sequence in embodiments of the present disclosure.
FIG. 5 is a diagram illustrating a substrate processing sequence in embodiments of the present disclosure.
FIG. 6 is a diagram illustrating a substrate processing sequence in embodiments of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

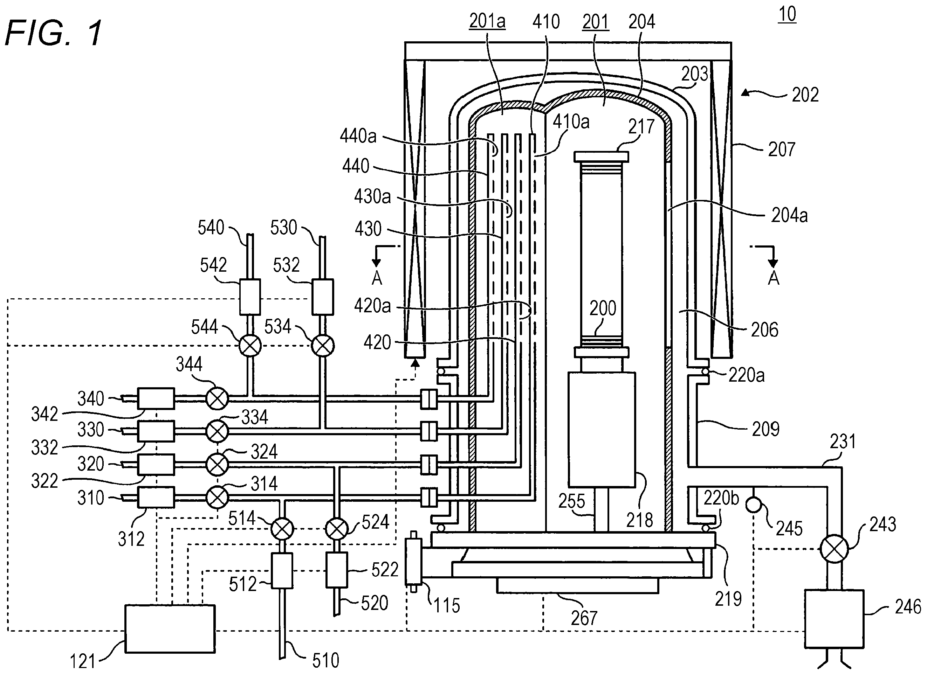

Hereinafter, description will be made with reference to FIGS. 1 to 6. Note that the drawings used in the following description are all schematic, and a dimensional relationship among elements, a ratio among the elements, and the like illustrated in the drawings do not necessarily coincide with actual ones. In addition, a dimensional relationship among elements, a ratio among the elements, and the like do not necessarily coincide among the plurality of drawings.

### (1) Configuration of Substrate Processing Apparatus

A substrate processing apparatus 10 includes a processing furnace 202 including a heater 207 serving as a heating means (heating mechanism or heating system). The heater 207 has a cylindrical shape, and is vertically installed by being supported by a heater base (not illustrated) serving as a holding plate.

Inside the heater 207, an outer tube 203 that constitutes a processing container is disposed concentrically with the heater 207. For example, the outer tube 203 is made of a heat-resistant material, such as quartz (SiO2) or silicon carbide (SiC), and is formed in a cylindrical shape in which an upper end is closed and a lower end is open. Below the outer tube 203, a manifold (inlet flange) 209 is disposed concentrically with the outer tube 203. The manifold 209 is made of, for example, a metal such as stainless steel (SUS) and is formed in a cylindrical shape with an upper end and a lower end opened. Between the upper end portion of the manifold 209 and the outer tube 203, an O-ring 220a serving as a seal member is disposed. When the manifold 209 is supported by the heater base, the outer tube 203 is vertically installed.

Inside the outer tube 203, an inner tube 204 constituting the processing container is disposed. For example, the inner tube 204 is made of a heat-resistant material, such as quartz (SiO2) or silicon carbide (SiC), and is formed in a cylindrical shape in which an upper end is closed and a lower end is open. The outer tube 203, the inner tube 204, and the manifold 209 mainly constitute the processing container. In a cylindrical hollow portion of the processing container (inside the inner tube 204), a processing chamber 201 is formed.

The processing chamber 201 is configured to be capable of accommodating wafers 200 serving as substrates in a state where the wafers 200 are arranged in multiple stages in the vertical direction in a horizontal posture by a boat 217 described later.

In the processing chamber 201, nozzles 410, 420, 430, and 440 are disposed so as to penetrate a side wall of the manifold 209 and the inner tube 204. To the nozzles 410, 420, 430, and 440, gas supply pipes 310, 320, 330, and 340 are connected, respectively. Note that the processing furnace 202 of the present embodiment is not limited to the above-described form.

Mass flow controllers (MFCs) 312, 322, 332, and 342, which are flow rate controllers, are disposed in the gas supply pipes 310, 320, 330, and 340, respectively. In addition, valves 314, 324, 334, and 344, which are on-off valves, are disposed in the gas supply pipes 310, 320, 330, and 340, respectively. To downstream sides of the valves 314, 324, 334, and 344 of the gas supply pipes 310, 320, 330, and 340, gas supply pipes 510, 520, 530, and 540 that supply an inert gas are connected, respectively. MFCs 512, 522, 532, and 542, which are flow rate controllers, and valves 514, 524, 534, and 544, which are on-off valves, are disposed in the gas supply pipes 510, 520, 530, and 540 in this order from an upstream side, respectively.

To distal end portions of the gas supply pipes 310, 320, 330, and 340, nozzles 410, 420, 430, and 440 are connected, respectively. The nozzles 410, 420, 430, and 440 are configured as L-shaped nozzles, and horizontal portions thereof are disposed so as to penetrate a side wall of the manifold 209 and the inner tube 204. Vertical portions of the nozzles 410, 420, 430, and 440 are disposed inside a spare chamber 201a having a channel shape (groove shape) formed so as to protrude outward in a radial direction of the inner tube 204 and to extend in the vertical direction, and are disposed upward (upward in an arrangement direction of the wafers 200) along an inner wall of the inner tube 204 in the spare chamber 201a.

The nozzles 410, 420, 430, and 440 are disposed so as to extend from a lower area of the processing chamber 201 to an upper area of the processing chamber 201, and a plurality of gas supply holes 410a, a plurality of gas supply holes 420a, a plurality of gas supply holes 430a, and a plurality of gas supply holes 440a are formed at positions facing the wafers 200, respectively. As a result, a processing gas is supplied from each of the gas supply holes 410a, 420a, 430a, and 440a of the nozzles 410, 420, 430, and 440 to the wafers 200. The plurality of gas supply holes 410a, the plurality of gas supply holes 420a, the plurality of gas supply holes 430a, and the plurality of gas supply holes 440a are formed from a lower portion to an upper portion of the inner tube 204, have the same opening area, and are formed at the same opening pitch. Note that the gas supply holes 410a, 420a, 430a, and 440a are not limited to the above-described form. For example, the opening area may be gradually increased from a lower portion to an upper portion of the inner tube 204. As a result, a flow rate of a gas supplied from the gas supply holes 410a, 420a, 430a, and 440a can be made more uniform.

The plurality of gas supply holes 410a, the plurality of gas supply holes 420a, the plurality of gas supply holes 430a, and the plurality of gas supply holes 440a of the nozzles 410, 420, 430, and 440 are formed at height positions from a lower portion to an upper portion of the boat 217 described later. Therefore, the processing gas supplied from the gas supply holes 410a, 420a, 430a, and 440a of the nozzles 410, 420, 430, and 440 into the processing chamber 201 is supplied to the entire region of the wafers 200 accommodated from the lower portion to the upper portion of the boat 217. The nozzles 410, 420, 430, and 440 need to be disposed so as to extend from a lower area to an upper area of the processing chamber 201, and may be disposed so as to extend to the vicinity of a ceiling of the boat 217.

From the gas supply pipe 310, a first processing gas is supplied into the processing chamber 201 via the MFC 312, the valve 314, and the nozzle 410. In the present disclosure, the first processing gas is also referred to as a gas containing a first element (first element-containing gas).

From the gas supply pipe 320, a second processing gas is supplied into the processing chamber 201 via the MFC 322, the valve 324, and the nozzle 420. In the present disclosure, the second processing gas is also referred to as a first modifying gas or a first reducing gas.

From the gas supply pipe 330, a third processing gas is supplied into the processing chamber 201 via the MFC 332, the valve 334, and the nozzle 430. In the present disclosure, the third processing gas is used as a reactant gas to be reacted with a source gas. In the present disclosure, the third processing gas is also referred to as a second modifying gas or a second reducing gas.

From the gas supply pipe 340, a fourth processing gas is supplied into the processing chamber 201 via the MFC 342, the valve 344, and the nozzle 440. In the present disclosure, the fourth processing gas is also referred to as a gas containing a second element (second element-containing gas).

Note that from the gas supply pipe 340, a fifth processing gas may be supplied into the processing chamber 201 via the MFC 342, the valve 344, and the nozzle 440. In the present disclosure, the fifth processing gas is also referred to as a gas containing a third element (third element-containing gas). Note that the fourth processing gas may be the same as the fifth processing gas.

From the gas supply pipes 510, 520, 530, and 540, for example, a nitrogen (N2) gas is supplied as an inert gas into the processing chamber 201 via the MFCs 512, 522, 532, and 542, the valves 514, 524, 534, and 544, and the nozzles 410, 420, 430, and 440, respectively. Hereinafter, an example of using a N₂ gas as the inert gas will be described, but as the inert gas, for example, a rare gas such as an argon (Ar) gas, a helium (He) gas, a neon (Ne) gas, or a xenon (Xe) gas may be used in addition to the N₂ gas.

The gas supply pipes 310, 320, 330, and 340, the MFCs 312, 322, 332, and 342, the valves 314, 324, 334, and 344, and the nozzles 410, 420, 430, and 440 mainly constitute a processing gas supply system, but only the nozzles 410, 420, 430, and 440 may be considered as the processing gas supply system. The processing gas supply system may be simply referred to as a gas supply system. When the first processing gas is caused to flow from the gas supply pipe 310, the gas supply pipe 310, the MFC 312, and the valve 314 mainly constitute a first processing gas supply system, but the nozzle 410 may be included in the first processing gas supply system. When the second processing gas is caused to flow from the gas supply pipe 320, the gas supply pipe 320, the MFC 322, and the valve 324 mainly constitute a second processing gas supply system, but the nozzle 420 may be included in the second processing gas supply system. When the third processing gas is caused to flow from the gas supply pipe 330, the gas supply pipe 330, the MFC 332, and the valve 334 mainly constitute a third processing gas supply system, but the nozzle 430 may be included in the third processing gas supply system. When the fourth processing gas is caused to flow from the gas supply pipe 340, the gas supply pipe 340, the MFC 342, and the valve 344 mainly constitute a fourth processing gas supply system, but the nozzle 440 may be included in the fourth processing gas supply system. The gas supply pipes 510, 520, 530, and 540, the MFCs 512, 522, 532, and 542, and the valves 514, 524, 534, and 544 mainly constitute an inert gas supply system.

In a gas supply method in the present embodiment, a gas is transferred via the nozzles 410, 420, 430, and 440 disposed in the spare chamber 201a in an annular and vertically long space defined by an inner wall of the inner tube 204 and end portions of the plurality of wafers 200. Then, a gas is ejected into the inner tube 204 from the plurality of gas supply holes 410a, 420a, 430a, and 440a of the nozzles 410, 420, 430, and 440 which are disposed at positions facing the wafers 200. More specifically, for example, the processing gas or the like is ejected in a direction parallel to surfaces of the wafers 200 through the gas supply holes 410a of the nozzle 410, the gas supply holes 420a of the nozzle 420, the gas supply holes 430a of the nozzle 430, and the gas supply holes 440a of the nozzle 440.

An exhaust hole (exhaust port) 204a is a through-hole formed in a side wall of the inner tube 204 at a position facing the nozzles 410, 420, 430, and 440, and is, for example, a slit-shaped through-hole opened so as to be elongated in the vertical direction. The gas, which has been supplied into the processing chamber 201 from the gas supply holes 410a, 420a, 430a, and 440a of the nozzles 410, 420, 430, and 440 and has flowed on the surfaces of the wafers 200, flows into an exhaust path 206 which is a gap formed between the inner tube 204 and the outer tube 203 through the exhaust hole 204a. Then, the gas that has flowed into the exhaust path 206 flows into an exhaust pipe 231 and is discharged to the outside of the processing furnace 202.

The exhaust hole 204a is formed at a position facing the plurality of wafers 200, and the gas supplied from the gas supply holes 410a, 420a, 430a, and 440a to the vicinity of the wafers 200 in the processing chamber 201 flows in the horizontal direction and then flows into the exhaust path 206 via the exhaust hole 204a. The exhaust hole 204a is not limited to being configured as a slit-shaped through-hole, and may be formed by a plurality of holes.

An exhaust pipe 231 for exhausting the atmosphere in the processing chamber 201 is disposed in the manifold 209. To the exhaust pipe 231, a pressure sensor 245 serving as a pressure detector that detects a pressure in the processing chamber 201, an auto pressure controller (APC) valve 243, and a vacuum pump 246 serving as a vacuum exhaust device are connected in this order from an upstream side. The APC valve 243 can perform vacuum exhaust and vacuum exhaust stop in the processing chamber 201 by opening and closing the valve in a state where the vacuum pump 246 is operated, and furthermore, can adjust a pressure in the processing chamber 201 by adjusting the degree of valve opening in a state where the vacuum pump 246 is operated. The exhaust hole 204a, the exhaust path 206, the exhaust pipe 231, the APC valve 243, and the pressure sensor 245 mainly constitute an exhaust system. The vacuum pump 246 may be included in the exhaust system.

Below the manifold 209, a seal cap 219 serving as a furnace opening lid capable of hermetically closing a lower end opening of the manifold 209 is disposed. The seal cap 219 is configured to abut against a lower end of the manifold 209 from a lower side in the vertical direction. The seal cap 219 is made of, for example, a metal such as SUS and is formed in a disk shape. On an upper surface of the seal cap 219, an O-ring 220b serving as a seal member abutting against the lower end of the manifold 209 is disposed. On a side of the seal cap 219 opposite to the processing chamber 201, a rotation mechanism 267 that rotates the boat 217 that accommodates the wafers 200 is disposed. A rotation shaft 255 of the rotation mechanism 267 penetrates the seal cap 219 and is connected to the boat 217. The rotation mechanism 267 is configured to rotate the wafers 200 by rotating the boat 217. The seal cap 219 is configured to be lifted and lowered in the vertical direction by a boat elevator 115 serving as a lifting/lowering mechanism vertically disposed outside the outer tube 203. The boat elevator 115 is configured to be able to load the boat 217 into the processing chamber 201 and unload the boat 217 out of the processing chamber 201 by lifting and lowering the seal cap 219. The boat elevator 115 is configured as a transfer device (transfer system) that transfers the boat 217 and the wafers 200 accommodated in the boat 217 to the inside and the outside of the processing chamber 201.

The boat 217 serving as a substrate support tool is configured such that a plurality of, for example, 25 to 200 wafers 200 can be arranged at intervals in the vertical direction in a horizontal posture and in a state where the centers thereof are aligned with each other. The boat 217 is made of, for example, a heat-resistant material such as quartz or SiC. In a lower portion of the boat 217, for example, a heat insulating plate 218 made of a heat-resistant material such as quartz or SiC is supported in a horizontal posture in multiple stages (not illustrated). This configuration makes it difficult for heat from the heater 207 to be transferred to the seal cap 219. Note that the present embodiment is not limited to the above-described form. For example, a heat insulating tube configured as a cylindrical member made of a heat resistant material such as quartz or SiC may be disposed without disposing the heat insulating plate 218 at the lower portion of the boat 217.

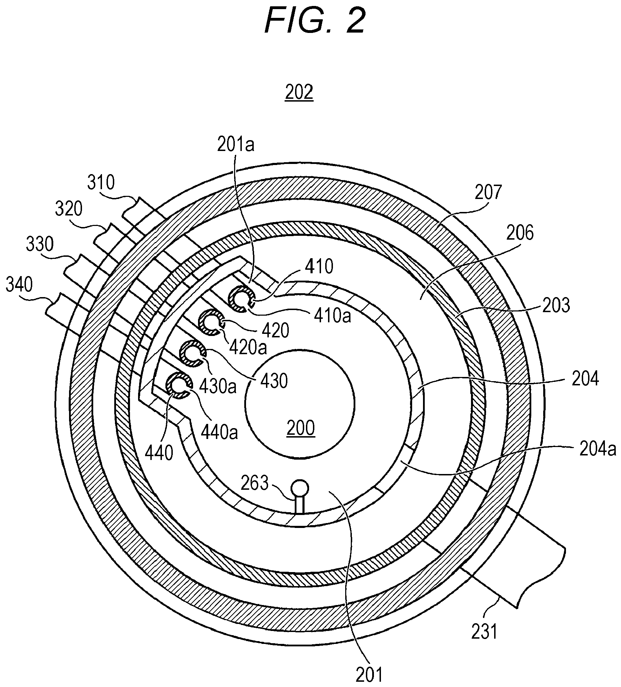

As illustrated in FIG. 2, a temperature sensor 263 serving as a temperature detector is disposed in the inner tube 204, and it is configured such that the temperature in the processing chamber 201 has a desired temperature distribution by adjusting an energization amount to the heater 207 based on temperature information detected by the temperature sensor 263. The temperature sensor 263 is formed in an L shape similarly to the nozzles 410, 420, 430, and 440, and is disposed along an inner wall of the inner tube 204.

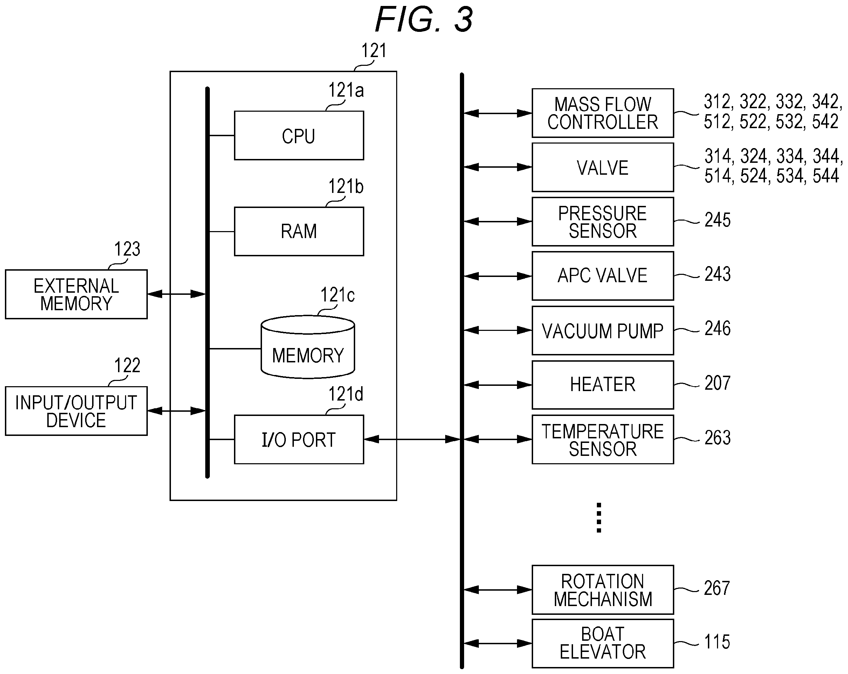

As illustrated in FIG. 3, the controller 121 is configured as a computer including a central processing unit (CPU) 121a, a random access memory (RAM) 121b, a memory 121c, and an I/O port 121d. The RAM 121b, the memory 121c, and the I/O port 121d are configured to be able to exchange data with the CPU 121a via an internal bus. An input/output device 122 configured as, for example, a touch panel is connected to the controller 121.

The memory 121c is constituted by, for example, a flash memory or a hard disk drive (HDD). In the memory 121c, a control program that controls an operation of the substrate processing apparatus, a process recipe in which a procedure, a condition, and the like of a method of manufacturing a semiconductor device described later are described, and the like are readably stored. The process recipe is a combination formed so as to cause the controller 121 to execute steps in a method of manufacturing a semiconductor device described later to obtain a predetermined result, and functions as a program. Hereinafter, the process recipe, the control program, and the like are also collectively and simply referred to as a program. In the present specification, the term "program" may include the process recipe alone, the control program alone, or a combination of the process recipe and the control program. The RAM 121b is configured as a memory area (work area) in which programs, data, and the like read by the CPU 121a are temporarily stored.

The I/O port 121d is connected to the MFCs 312, 322, 332, 342, 512, 522, 532, and 542, the valves 314, 324, 334, 344, 514, 524, 534, and 544, the pressure sensor 245, the APC valve 243, the vacuum pump 246, the heater 207, the temperature sensor 263, the rotation mechanism 267, the boat elevator 115, and the like.

The CPU 121a is configured to read the control program from the memory 121c to execute the control program, and to read a recipe and the like from the memory 121c in response to an input of an operation command from the input/output device 122 and the like. The CPU 121a is configured to be able to control various gases flow rate adjustment operations of the MFCs 312, 322, 332, 342, 512, 522, 532, and 542, open and close operations of the valves 314, 324, 334, 344, 514, 524, 534, and 544, an open and close operation of the APC valve 243, a pressure adjustment operation of the APC valve 243 based on the pressure sensor 245, a temperature adjustment operation of the heater 207 based on the temperature sensor 263, start and stop of the vacuum pump 246, boat 217 rotation and a boat 217 rotation speed adjustment operation of the rotation mechanism 267, a boat 217 lifting and lowering operation of the boat elevator 115, an operation of accommodating the wafers 200 into the boat 217, and the like according to the contents of the read recipe.

The controller 121 can be configured by installing the above-described program stored in an external memory (for example, a magnetic tape, a magnetic disk such as a flexible disk or a hard disk, an optical disk such as a CD or a DVD, a magneto-optical disk such as an MO, or a semiconductor memory such as a USB memory or a memory card) 123 in a computer. The memory 121c and the external memory 123 are configured as computer-readable recording media. Hereinafter, the memory 121c and the external memory 123 are collectively and simply referred to as a recording medium. In the present specification, the term "recording medium" may include the memory 121c alone, the external memory 123 alone, or both of these. A program may be provided to a computer using a communication means such as the Internet or a dedicated line without using the external memory 123.

### (2) Substrate processing step (method of processing substrate)

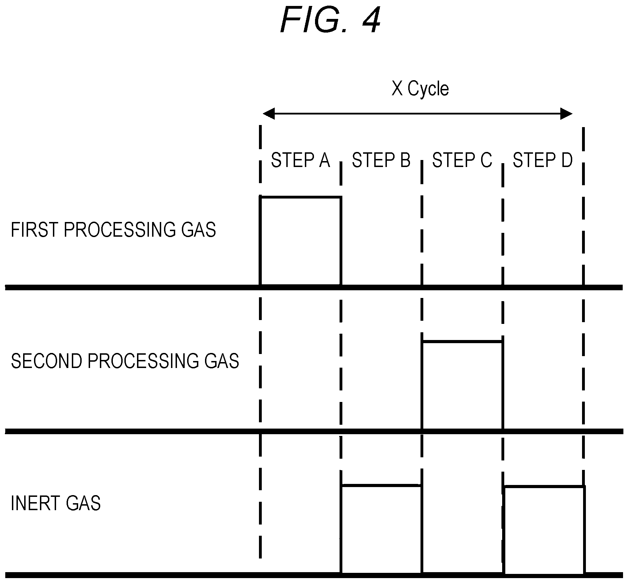

As one step of a semiconductor device (device) manufacturing process, an example of a step of forming a first element-containing film containing the first element on the wafer 200 will be described with reference to FIG. 4. This step is performed using the process furnace 202 of the substrate processing apparatus 10 described above. In the following description, operations of the units constituting the substrate processing apparatus 10 are controlled by the controller 121.

A substrate processing step (semiconductor device manufacturing step) according to the present embodiment includes:
(a) supplying a first processing gas containing a first element and a halogen to the wafers 200;
(b) supplying a second processing gas having a N-N bond and a N-H bond to the wafers 200; and
(c) performing (a) and (b) a predetermined number of times in a state where the wafers 200 are heated to a temperature of 250 degrees C or lower to form a first film containing the first element.

In the present specification, the term "wafer" may mean a "wafer itself" or a "laminate of a wafer and a predetermined layer, film, or the like formed on a surface of the wafer". In the present specification, the term "surface of a wafer" may mean a "surface of a wafer itself" or a "surface of a predetermined layer, film, or the like formed on the wafer". In the present specification, the term "substrate" is synonymous with the word "wafer".

### (Wafer loading)

When the boat 217 is charged with the plurality of wafers 200 (wafer charge), as illustrated in FIG. 1, the boat 217 supporting the plurality of wafers 200 is lifted and loaded into the processing chamber 201 of the processing container (boat loading) by the boat elevator 115 and accommodated in the processing container. In this state, the seal cap 219 closes a lower end opening of the outer tube 203 through the O-ring 220.

### (Pressure adjustment and temperature adjustment)

The vacuum pump 246 performs vacuum exhaust such that the inside of the processing chamber 201, that is, a space where the wafers 200 are present has a desired pressure (degree of vacuum). At this time, the pressure in the processing chamber 201 is measured by the pressure sensor 245, and the APC valve 243 is feedback-controlled based on the measured pressure information (pressure adjustment). The vacuum pump 246 maintains a state of being constantly operated at least until the processing on the wafers 200 is completed. The inside of the processing chamber 201 is heated by the heater 207 so as to have a predetermined temperature. At this time, an energization amount to the heater 207 is feedback-controlled based on temperature information detected by the temperature sensor 263 such that the inside of the processing chamber 201 has a predetermined temperature distribution. The inside of the processing chamber 201 is continuously heated by the heater 207 at least until processing on the wafers 200 is completed.

### (Supply of first processing gas, step A)

The valve 314 is opened to cause the first processing gas to flow into the gas supply pipe 310. The first processing gas whose flow rate is adjusted by the MFC 312 is supplied from the gas supply holes 410a of the nozzle 410 into the processing chamber 201, and is exhausted from the exhaust pipe 231.

At this time, the APC valve 243 is adjusted to set a pressure in the processing chamber 201 to, for example, a pressure within a range of 1 to 3,990 Pa. The first processing gas supply flow rate controlled by the MFC 312 is, for example, a flow rate within a range of 0.01 to 3 slm. Hereinafter, the temperature of the heater 207 is set such that the temperature of the wafer 200 is within a range of, for example, 100 degrees C to 400 degrees C. Specifically, the temperature of the wafer 200 is set to 250 degrees C or lower. More specifically, the temperature of the wafer 200 is set to 180 degrees C or higher and 220 degrees C or lower. This temperature is maintained at least during formation of the first film. Note that expression of a numerical range such as "1 to 3,990 Pa" in the present disclosure means that a lower limit value and an upper limit value are included in the range. Therefore, for example, "1 to 3,990 Pa" means "1 Pa or more and 3,990 Pa or less". The same applies to other numerical ranges.

At this time, the first processing gas is supplied to the wafers 200. As the first processing gas, a gas containing the first element and a halogen element, for example, a titanium tetrachloride (TiCl₄) gas, which is a gas containing titanium (Ti) and chlorine (Cl), can be used. When a TiCl₄ gas is used as the first element-containing gas, TiClₓ (X is an integer of 4 or less) is adsorbed on the wafer 200 (base film on a surface) by supply of the TiCl₄ gas to form a Ti-containing layer.

### (Purge, step A)

After a lapse of a predetermined time from start of supply of the first processing gas, for example, after 0.1 to 10 seconds, the valve 314 is closed to stop supply of the first processing gas. At this time, with the APC valve 243 of the exhaust pipe 231 open, the inside of the processing chamber 201 is vacuum-exhausted by the vacuum pump 246, and a residual gas is removed from the surfaces of the wafers 200 to remove the first processing gas that remains inside the processing chamber 201 and has not reacted and a reaction by-product from the inside of the processing chamber 201. At this time, the valves 514, 524, 534, and 542 are opened to supply an inert gas serving as a purge gas into the processing chamber 201. The inert gas acts as a purge gas, and can enhance an effect of removing a residual gas from the surfaces of the wafers 200 to remove the first processing gas that remains inside the processing chamber 201 and has not reacted and a reaction by-product from the inside of the processing chamber 201. The inert gas supply flow rate controlled by each of the MFCs 512, 522, 532, and 542 is, for example, 0.1 to 30 slm.

### (Supply of second processing gas, step C)

After a lapse of a predetermined time from start of purge, for example, after 0.1 to 10 seconds, the valves 514, 524, 534, and 544 are closed to stop supply of the inert gas into the processing chamber 201. At this time, the valve 324 is opened to cause the second processing gas to flow into the gas supply pipe 320. The flow rate of the second processing gas is adjusted by the MFC 322, and the second processing gas is supplied from the gas supply holes 420a of the nozzle 420 into the processing chamber 201, and is exhausted from the exhaust pipe 231. At this time, the second processing gas is supplied to the wafers 200. Note that, at this time, the valve 524 may be simultaneously opened to cause the inert gas to flow into the gas supply pipe 520. In addition, in order to prevent the second processing gas from entering the nozzles 410, 430, and 440, the valves 514, 534, and 544 may be opened to cause the inert gas to flow into the gas supply pipes 510, 530, and 540.

At this time, the APC valve 243 is adjusted to set a pressure in the processing chamber 201 to, for example, a pressure within a range of 1 to 3,990 Pa. The second processing gas supply flow rate controlled by the MFC 322 is, for example, a flow rate within a range of 0.1 to 30 slm. Time during which the second processing gas is supplied to the wafers 200 is within a range of, for example, 0.01 to 30 seconds.

At this time, the second processing gas is supplied to the wafers 200. Here, as the second processing gas, for example, a gas having a N-N bond and a N-H bond can be used. Examples of such a gas include a hydrazine (N₂H₄) gas. The N₂H₄ gas serving as the second processing gas has a N-N bond and a N-H bond. Out of these bonds, the N-N bond is easily dissociated as compared with the N-H bond, and NHₓ is generated from N₂H₄. Here, x is 1 or 2. The NHₓ undergoes a substitution reaction with at least a part of the Ti-containing layer formed on the wafer 200. During the substitution reaction, Ti contained in the Ti-containing layer and N contained in the N₂H₄ gas are bonded to each other to form a TiN layer on the wafer 200. Specifically, TiClₓ adsorbed on the wafer 200 reacts with N₂H₄ or NHₓ to form a TiN film on the wafer 200 having an oxide film formed on a surface thereof, and a coverage of the TiN film can be improved. In addition, during the substitution reaction, reaction by-products such as HCl, ammonium chloride (NH₄Cl), and H₂ are generated.

### (Purge, step D)

After a lapse of a predetermined time from start of supply of the second processing gas, for example, after 0.01 to 60 seconds, the valve 324 is closed to stop supply of the second processing gas. At this time, with the APC valve 243 of the exhaust pipe 231 open, the inside of the processing chamber 201 is vacuum-exhausted by the vacuum pump 246, and a residual gas is removed from the surfaces of the wafers 200 to remove the second processing gas that remains inside the processing chamber 201 and has not reacted or has contributed to formation of the film and a reaction by-product from the inside of the processing chamber 201. At this time, the valves 514, 524, 534, and 544 are opened to supply the inert gas serving as a purge gas into the processing chamber 201. The inert gas acts as a purge gas, and can enhance an effect of removing a residual gas from the surfaces of the wafers 200 to remove the second processing gas that remains inside the processing chamber 201 and has not reacted and the above-described reaction by-products from the inside of the processing chamber 201. The inert gas supply flow rate controlled by each of the MFCs 512, 522, 532, and 542 is, for example, 0.1 to 30 slm.

That is, the second processing gas that remains inside the processing chamber 201 and has not reacted or has contributed to formation of the film and the above-described reaction by-products are removed from the inside of the processing chamber 201. The inert gas acts as a purge gas.

### (Predetermined number of times of X execution)

By performing a cycle in which the above-described steps A to D are sequentially performed a predetermined number of times (X times), one or more times, the first film having a predetermined thickness is formed on the wafer 200. Here, the first film is a film containing Ti serving as the first element, and specifically, a TiN film is formed.

### (After-purge and return to atmospheric pressure)

The inert gas is supplied from each of the gas supply pipes 510 to 530 into the processing chamber 201, and is exhausted from the exhaust pipe 231. The inert gas acts as a purge gas, whereby the inside of the processing chamber 201 is purged with the inert gas, and a gas remaining in the processing chamber 201 and a reaction by-product are removed from the inside of the processing chamber 201 (after purge). Thereafter, the atmosphere in the processing chamber 201 is replaced with an inert gas (inert gas replacement), and the pressure in the processing chamber 201 is returned to a normal pressure (return to atmospheric pressure).

### (Wafer unloading)

Then, the seal cap 219 is lowered by the boat elevator 115, and a lower end of the outer tube 203 is opened. Then, the processed wafers 200 are unloaded (boat unloading) from the lower end of the outer tube 203 to the outside of the outer tube 203 in a state of being supported by the boat 217. Thereafter, the processed wafers 200 are taken out from the boat 217 (wafer discharge).

### (3) Effects of present embodiment

According to the present embodiment, one or more effects described below can be obtained.
(a) By using a gas having a N-N bond and a N-H bond as the second processing gas, reduction (nitridation) of a layer formed on the wafer 200 can be promoted. In the gas having a N-N bond and a N-H bond, the N-N bond is easily dissociated, and a NH-ligand is generated by dissociation of the N-N bond. With the NH-ligand, for example, nitrogen (N) can be removed while Cl of TiClₓ adsorbed on the wafer 200, which is generated when a gas containing a halogen, specifically, TiCl₄ is used as the first processing gas, is removed. By removing Cl of TiClₓ, adsorption inhibition due to steric hindrance of TiClₓ can be suppressed.
(b) By using a gas having a N-N bond and a N-H bond as the second processing gas, a layer formed on the wafer 200 can be reduced (nitrided) particularly even at a low temperature such as 100 degrees C to 400 degrees C. In particular, a decrease in a speed of forming the first film to be formed on the wafer 200 can be suppressed even at a low temperature such as 250 degrees C or lower as compared with a speed of forming the first film at a similar temperature using a gas having no N-N bond and no N-H bond. In addition, by setting the temperature to 250 degrees C or lower, the amount of decomposition of the second processing gas before being supplied to the wafers 200 can be reduced. When the second processing gas is decomposed before being supplied to the wafers 200, NHₓ generated by the decomposition of the second processing gas is exhausted without being supplied to the wafers 200, and the amount of reduction (nitridation) of the layer containing the first element formed on the wafer 200 decreases. In addition, NHₓ generated by decomposition of the second processing gas may further undergo a reaction such as decomposition to generate N₂ or H₂ having low reactivity. By setting the temperature to 250 degrees C or lower, the amount of decomposition of the second processing gas before being supplied to the wafers 200 can be reduced.
(c) By setting the temperature of the wafers 200 at the time of forming the first film to 180 degrees C or higher, generation of a by-product such as NH₄Cl can be suppressed. The amount of NH₄Cl generated increases below 180 degrees C. By generating a by-product such as NH₄Cl, the by-product inhibits adsorption of molecules of the first processing gas on the wafers 200. As a result, the first film forming speed decreases. In addition, there is a problem that NH₄Cl is incorporated into the first film to deteriorate the characteristics of the first film.
(d) By setting the temperature of the wafer 200 at the time of forming the first film to 220 degrees C or lower, decomposition of the second processing gas having a N-N bond and a N-H bond before reaching the wafer 200 can be suppressed. In other words, when the temperature of the wafer 200 is set to a temperature higher than 220 degrees C, the second processing gas is decomposed before reaching the wafer 200, and the amount of NHₓ supplied to the wafer 200 decreases. As a result, the first film forming speed decreases.
(e) By using the second processing gas having a N-N bond and a N-H bond, a decrease in the first film forming speed can be suppressed even if the surface of the wafer 200 is an oxide film. When such a second processing gas is not used, in a case where the surface of the wafer 200 is an oxide film, a predetermined amount of the first processing gas adsorbed cannot be obtained, and the first film forming speed decreases. When the surface of the wafer 200 is an oxide film and the first processing gas contains a halogen element, molecules of the first processing gas are not adsorbed on a surface of the oxide film in some cases. As a result, the amount of molecules of the first processing gas adsorbed on the oxide film at the predetermined number of times X = 1 decreases, and the second processing gas at the predetermined number of times X = 1 is supplied to the oxide film. At this time, the surface of the oxide film is terminated with a NH-group by the second processing gas. When the predetermined number of times X ≥ 2, the first processing gas is supplied to the terminal of the NH-group in the oxide film in such a state. Since the terminal of the NH-group and the halogen are easily bonded to each other, the amount of molecules of the first processing gas adsorbed on the oxide film at a predetermined number of times X ≥ 2 can be increased. That is, the first film forming speed can be increased.
(f) By supplying the decomposition product (NHₓ) of the second processing gas to the wafer 200 (particularly, the oxide film), the amount of the terminal of the NH-group formed on the surface of the wafer 200 can be increased.

### (4) Other Embodiments

The embodiment of the present disclosure has been specifically described above. However, the present disclosure is not limited to the above-described embodiment, and various modifications can be made without departing from the gist thereof.

### (Modified Example 1)

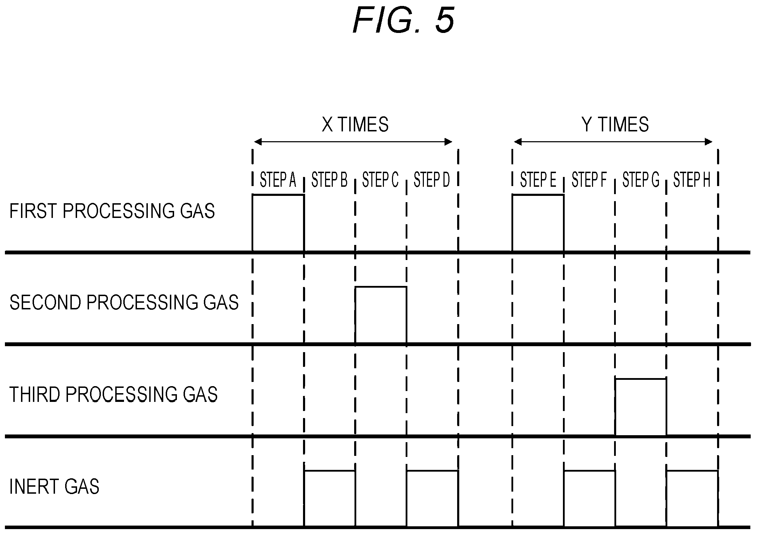

FIG. 5 illustrates Modified Example 1 of a substrate processing sequence in the embodiment of the present disclosure. Modified Example 1 is a substrate processing sequence in which steps E to H are performed Y times after steps A to D are performed X times. Here, the contents of steps A to D are similar to those described above. Since steps E, F, and H are similar to steps A, B, and D described above, description thereof is omitted. Step G will be described.

### (Supply of third processing gas, step G)

In step G, after a lapse of a predetermined time from start of purge in step F, for example, after 0.1 to 10 seconds, the valves 514, 524, 534, and 544 are closed to stop supply of the inert gas into the processing chamber 201. At this time, the valve 334 is opened to cause the third processing gas to flow into the gas supply pipe 330. The flow rate of the third processing gas is adjusted by the MFC 332, and the third processing gas is supplied from the gas supply holes 430a of the nozzle 430 into the processing chamber 201, and is exhausted from the exhaust pipe 231. At this time, the third processing gas is supplied to the wafers 200. Note that, at this time, the valve 534 may be simultaneously opened to cause the inert gas to flow into the gas supply pipe 520. In addition, in order to prevent the third processing gas from entering the nozzles 410, 420, and 440, the valves 514, 524, and 544 may be opened to cause the inert gas to flow into the gas supply pipes 510, 520, and 540.

At this time, the APC valve 243 is adjusted to set a pressure in the processing chamber 201 to, for example, a pressure within a range of 1 to 3,990 Pa. The third processing gas supply flow rate controlled by the MFC 322 is, for example, a flow rate within a range of 0.1 to 30 slm. Time during which the third processing gas is supplied to the wafers 200 is within a range of, for example, 0.01 to 30 seconds.

At this time, the third processing gas is supplied to the wafers 200. Here, as the third processing gas, for example, a gas having a N-H bond can be used. Examples of such a gas include a gas containing at least one of NH₃, diazene (N₂H₂), triazene (N₃H₃), hydrazine (N₂H₄), and another gas containing an amine group. Note that the third processing gas may be the same as the second processing gas, but a different type of gas from the second processing gas may be used as the third processing gas. When a N₂H₄ gas is used as the second processing gas, a NH₃ gas is used as the third processing gas. By using the N₂H₄ gas, the above-described remarkable effect can be obtained. However, when the N₂H₄ gas is used, there is a problem that film formation cost increases because the gas is expensive. Here, a relatively inexpensive NH₃ gas may be used as the third processing gas.

### (Purge, step H)

After a lapse of a predetermined time from start of supply of the third processing gas, for example, after 0.01 to 60 seconds, the valve 334 is closed to stop supply of the third processing gas. After the third processing gas is stopped, purge similar to that in step D described above is performed.

### (Predetermined number of times of Y execution)

By performing a cycle in which the above-described steps E to H are sequentially performed a predetermined number of times (Y times), one or more times, a second film having a predetermined thickness is formed on the first film. Here, the second film is a film containing Ti serving as the first element, and specifically, a TiN film is formed.

According to Modified Example 1, in addition to the above-described effects, at least one of the following effects can be obtained.
(g) A film containing the first element can be formed while the amount of the second processing gas used is reduced.
(h) By forming the second film using the third processing gas in a state where the first film is formed, the first processing gas used for forming the second film is supplied to the first film, and therefore the amount of the first processing gas adsorbed on the first film can be increased. That is, at the time of forming the second film, an influence of a surface state (for example, presence or absence of an oxide film) of the wafer 200 can be suppressed, and a decrease in a second film forming speed can be suppressed.

### (Modified Example 2)

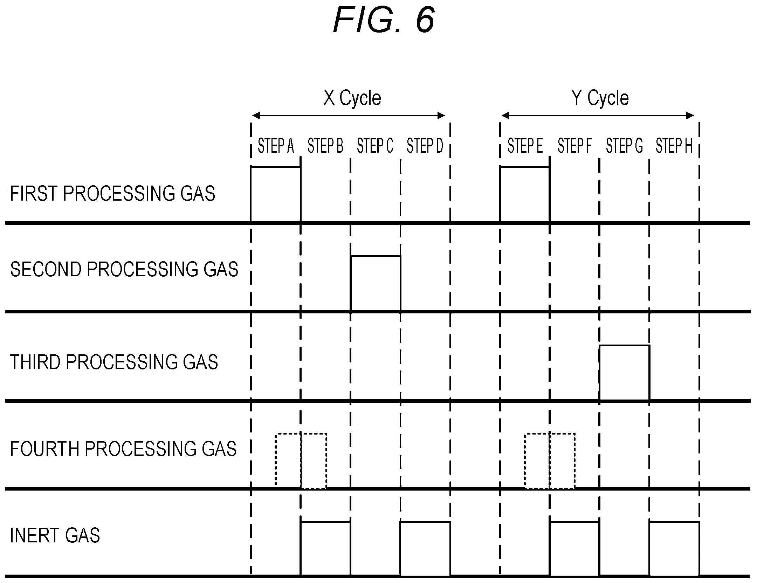

FIG. 6 illustrates Modified Example 2 of the substrate processing sequence in the embodiment of the present disclosure. Modified Example 2 is a substrate processing sequence in which the fourth processing gas is supplied in parallel with step A (step E). Note that the supply of the fourth processing gas is not essential as indicated by a broken line in FIG. 6, and is performed in parallel with at least one of steps A, B, E, and F. Hereinafter, as an example, a case where the fourth processing gas is supplied in steps A and B will be described. Since the contents of supplying the fourth processing gas in steps E and F are similar to those in steps A and B, description thereof is omitted.

### (Supply of fourth processing gas, in step A)

After a lapse of a predetermined time from start of supply of the first processing gas, the valve 344 is opened to cause the fourth processing gas to flow into the gas supply pipe 340. The fourth processing gas whose flow rate is adjusted by the MFC 342 is supplied from the gas supply holes 440a of the nozzle 440 into the processing chamber 201, and is exhausted from the exhaust pipe 231.

At this time, the APC valve 243 is adjusted to set a pressure in the processing chamber 201 to, for example, a pressure within a range of 1 to 3,990 Pa. The fourth processing gas supply flow rate controlled by the MFC 342 is, for example, a flow rate within a range of 0.1 to 5 slm. Time during which the first processing gas and the fourth processing gas are simultaneously supplied to the wafers 200 is, for example, within a range of 0.01 to 70 seconds.

At this time, the first processing gas and the fourth processing gas are simultaneously supplied to the wafers 200. That is, there is a timing when at least the first processing gas and the fourth processing gas are simultaneously supplied. As the fourth processing gas, a gas containing a second element different from the first element is used. Here, the second element is, for example, at least one of silicon (Si), boron (B), and phosphorus (P). The gas containing the second element is, for example, a gas containing the second element and hydrogen. Specifically, a silane-based gas such as silane (SiH₄), disilane (Si₂H₆), or trisilane (Si₃H₈), a borane-based gas such as monoborane (BH₃) or diborane (B₂H₆), and a phosphane-based gas such as a phosphine (PH₃) gas can be used. As the gas containing the second element, a gas that is hardly taken into the first film (second film) may be used. Examples of the gas that is hardly taken into the first film (second) film include a SiH₄ gas.

By supplying the fourth processing gas in this manner, for example, hydrogen chloride (HCl), which is a reaction by-product and is an adsorption inhibiting gas that inhibits film formation, is removed. Then, an adsorption site on which a reaction by-product such as HCl was adsorbed becomes empty, and an adsorption site on which the first element such as TiClₓ can be adsorbed can be formed on the surface of the wafer 200. By increasing the number of adsorption sites, a first film (second film) forming speed can be improved.

### (Supply of fourth processing gas, in step B)

After a lapse of a predetermined time from start of supply of the first processing gas, the valve 314 is closed to stop supply of the first processing gas. In other words, after a lapse of a predetermined time from start of supply of the fourth processing gas, supply of the first processing gas is stopped in the middle of supply of the fourth processing gas in a state where the fourth processing gas is being supplied. The flow rate of the fourth processing gas is adjusted by the MFC 342, and the fourth processing gas is supplied from the gas supply holes 440a of the nozzle 440 into the processing chamber 201, and is exhausted from the exhaust pipe 231. Note that, at this time, the valve 544 may be simultaneously opened to cause the inert gas to flow into the gas supply pipe 540. In addition, in order to prevent the fourth processing gas from entering the nozzles 410, 420, and 430, the valves 514, 524, and 534 may be opened to cause the inert gas to flow into the gas supply pipes 510, 520, and 530.

At this time, the APC valve 243 is adjusted to set a pressure in the processing chamber 201 to, for example, a pressure within a range of 1 to 3,990 Pa. Time during which only the fourth processing gas is supplied to the wafers 200 is, for example, within a range of 0.01 to 60 seconds.

At this time, only the fourth processing gas and the inert gas are supplied to the wafers 200. By supplying the fourth processing gas, for example, hydrogen chloride (HCl), which is a reaction by-product and is an adsorption inhibiting gas, is removed, an adsorption site on which HCl was adsorbed becomes empty, and an adsorption site on which TiClₓ can be adsorbed can be formed on the surface of the wafer 200.

Here, time from end of supply of the first processing gas to end of supply of the fourth processing gas is made longer than time from start of supply of the fourth processing gas supply to end of supply of the first processing gas. As a result, many adsorption sites on which TiClₓ can be adsorbed can be formed on the surface of the wafer 200.

### (Modified Example 3)

Although the formation of the first film (second film) containing the first element has been described above, the present disclosure is not limited thereto. For example, heat treatment may be performed after formation of the first film (second film). Here, in the heat treatment, the temperature is raised to a temperature higher than the temperature at the time of forming the first film (second film), for example, 450 degrees C to 550 degrees C, and the heat treatment is performed for a predetermined time. By performing the heat treatment at such a temperature, the amount of impurity contained in the first film (second film) can be reduced. Here, the impurity is a by-product as described above, and is, for example, Cl, HCl, or NH₄Cl. In addition, by supplying the second processing gas or the third processing gas to the wafers 200 at the time of heat treatment, elements contained in the second processing gas or the third processing gas can be supplied into the first film (second film) while the impurity in the first film (second film) is removed. Here, when the second processing gas or the third processing gas is the above-described gas, nitrogen (N) can be supplied to the first film (second film). As the gas used here, at least one of the second processing gas and the third processing gas is used. Nitridation efficiency of the first film (second film) can be improved by using the second processing gas, and cost of film formation can be reduced by using the third processing gas.

Note that at least one of the second processing gas and the third processing gas may be supplied during the temperature rise to the temperature of the heat treatment. By supplying at least one of the second processing gas and the third processing gas during the temperature rise, nitrogen can be bonded to an empty site where the impurity has been desorbed from the first film (second film) during the temperature rise, and a coverage of the first film (second film) can be improved.

### (Modified Example 4)

The first film (second film) described above reacts with oxygen in the atmosphere even at room temperature to be easily oxidized. When the first film (second film) is oxidized, there is a problem that the characteristics of the film are deteriorated. For example, when the first film (second film) is a conductive film, conductivity changes due to oxidation, and the characteristics of a semiconductor device are affected. In order to solve such a problem, a third film may be formed on the first film (second film). Here, the third film is, for example, a film containing an element different from the first element. For example, the third film is a film containing the second element. Examples of the second element here include elements of Groups 13 and 14 of the periodic table. Specific examples thereof include silicon (Si) and aluminum (Al). The film containing such an element can be formed, for example, by supplying a gas containing the above-described silicon and hydrogen at 450 degrees C to 550 degrees C. Specifically, the film containing such an element is formed by opening the valve 344 in a state where the wafers 200 are set to 450 degrees C to 550 degrees C to cause the fourth processing gas to flow into the gas supply pipe 340.

At this time, the APC valve 243 is adjusted to set a pressure in the processing chamber 201 to, for example, a pressure within a range of 1 to 3,990 Pa. The fourth processing gas supply flow rate controlled by the MFC 342 is, for example, a flow rate within a range of 0.1 to 5 slm. Time during which the fourth processing gas is supplied to the wafers 200 is, for example, within a range of 0.01 to 70 seconds.

Under such conditions, for example, by supplying a SiH₄ gas as the fourth processing gas, a decomposition reaction occurs in SiH₄ on the wafer 200, and a film containing Si can be formed on the first film (second film). By forming the film containing Si on the first film (second film) in this manner, it is possible to suppress oxidation of the first film (second film) even if the first film (second film) is exposed to the atmosphere. Furthermore, when the first film (second film) is the TiN film as described above, it is possible to suppress diffusion of fluorine (F) in a tungsten fluoride (WF₆) gas supplied at the time of forming a tungsten film to be formed next to the TiN film into the first film (second film) in a semiconductor device manufacturing process. That is, a barrier property can be improved. Note that, when the third film is formed of the Si film, the Si film can be sublimated by the WF₆ gas during formation of the tungsten film, and a possibility of affecting the characteristics of the semiconductor device can be reduced.

Note that by setting the temperature at which the third film is formed to a temperature similar to the heat treatment temperature described above, temperature adjustment time from the heat treatment to the formation of the third film can be shortened, and even if a series of substrate processing steps including the formation of the first film (second film) → the heat treatment → the formation of the third film is performed, it is possible to suppress a significant increase in the film formation time.

Note that, here, the fourth processing gas is used as the gas for forming the third film. However, when the second element is a third element different from the element contained in the fourth processing gas, a fifth processing gas containing the third element can be used. The fourth processing gas may be the same as the fifth processing gas.

### (Modified Example 5)

The second processing gas may be supplied before the first film described above is formed. As described above, in a gas containing a N-N bond and a N-H bond, the N-N bond is easily dissociated, and NHₓ is easily generated. By using this characteristic and supplying the second processing gas before formation of the first film, NHₓ can be supplied to the wafer 200 to form a terminal of the NH-group on the surface of the wafer 200. Since the first processing gas is supplied to the terminal of the NH-group, the amount of molecules of the first processing gas (for example, TiClₓ) adsorbed on the wafer 200 can be increased. That is, the first film forming speed can be improved. In addition, the amount of molecules of the first processing gas adsorbed on a plane of the wafer 200 can be increased, and flatness of the first film and continuity of the film can be improved. In addition, the amount of Cl desorbed from TiCl₄ can be reduced by a reaction between the terminal of the NH-group and TiCl₄. That is, the number of x of TiClₓ can be reduced, and the size of steric hindrance of TiClₓ can be reduced.

### (Modified Example 6)

In step C in which the first film described above is formed, an example in which the second processing gas is supplied has been described, but the present disclosure is not limited thereto, and the third processing gas may be supplied in step C. Here, in step C, the second processing gas and the third processing gas may be supplied simultaneously, may be supplied separately and sequentially, or may be supplied such that supply timings partially overlap with each other. In step C, by using both the second processing gas and the third processing gas, it is possible to reduce the amount of the second processing gas supplied while the nitridation amount is maintained.

Note that, in the above embodiment, the case where a TiCl₄ gas containing Ti and Cl is used as the first processing gas has been described, but the present disclosure is not limited thereto. As the first element-containing gas, a gas containing the first element and a halogen may be used. Here, the first element is, for example, at least one of zirconium (Zr), hafnium (Hf), molybdenum (Mo), ruthenium (Ru), aluminum (Al), gallium (Ga), Si, and germanium (Ge). The halogen is, for example, at least one of chlorine (Cl), fluorine (F), and bromine (Br). Note that the first element-containing gas in which the halogen is chlorine is referred to as a first element and a chlorine-containing gas. The present disclosure can also be suitably applied to a case of using such a gas.

In the Modified Example 2, the example (FIG. 6) in which supply of the fourth processing gas is continued after supply of the first processing gas has been described, but the present disclosure is not limited thereto. For example, a timing of end of supply of the first processing gas may coincide with a timing of end of supply of the fourth processing gas. Also in such a case, at least one of the effects of the present disclosure can be obtained.

In addition, in the above-described embodiment, an example has been described in which a film is formed using a substrate processing apparatus that is a batch type vertical apparatus that processes a plurality of substrates at a time, but the present disclosure is not limited thereto, and can be suitably applied to a case where a film is formed using a single wafer type substrate processing apparatus that processes one or several substrates at a time.

It is possible to individually prepare (prepare a plurality of) process recipes (programs in which a processing procedure, a processing condition, and the like are described) used for forming these various thin films according to the contents of substrate processing (film type, composition ratio, film quality, film thickness, processing procedure, processing condition, and the like of a thin film to be formed). Then, when substrate processing is started, an appropriate process recipe from among a plurality of process recipes according to the contents of the substrate processing may be appropriately selected. Specifically, a plurality of process recipes individually prepared according to the contents of the substrate processing may be stored (installed) in advance in the memory 121c included in the substrate processing apparatus via a telecommunication line or a recording medium (external memory 123) in which the process recipes are recorded. Then, when the substrate processing is started, the CPU 121a included in the substrate processing apparatus may appropriately select an appropriate process recipe from among the plurality of process recipes stored in the memory 121c according to the contents of the substrate processing. With such a configuration, one substrate processing apparatus can generally form thin films of various film types, composition ratios, film qualities, and film thicknesses with good reproducibility. In addition, it is possible to reduce an operation load (for example, an input load of a processing procedure, a processing condition, and the like) of an operator, and it is possible to quickly start the substrate processing while avoiding an operation error.

In addition, the present disclosure can also be achieved, for example, by changing a process recipe of an existing substrate processing apparatus. When a process recipe is changed, the process recipe according to the present disclosure can be installed in an existing substrate processing apparatus via a telecommunication line or a recording medium in which the process recipe according to the present disclosure is recorded, or a process recipe itself of an existing substrate processing apparatus can be changed to the process recipe according to the present disclosure by operating an input/output device of the existing substrate processing apparatus.

Furthermore, the present disclosure can be used for, for example, a word line portion of a NAND flash memory, a DRAM, or the like having a three-dimensional structure.

Although various typical embodiments of the present disclosure have been described above, the present disclosure is not limited to these embodiments, and these embodiments can be appropriately combined to be used.

According to the present disclosure, film quality of a film formed on a substrate can be improved.

While certain embodiments have been described, these embodiments have been presented by way of example only, and are not intended to limit the scope of the disclosures. Indeed, the embodiments described herein may be embodied in a variety of other forms. Furthermore, various omissions, substitutions, and changes in the form of the embodiments described herein may be made without departing from the disclosures. The accompanying claims and their equivalents are intended to cover such forms or modifications as would fall within the scope of the disclosures.

## Claims

1. A method of processing a substrate (200), comprising:
(a) supplying a first processing gas containing a first element and a halogen to the substrate (200);
(b) supplying a second processing gas including a N-N bond and a N-H bond to the substrate (200); and
(c) performing (a) and (b) X times, X being a natural number, in a state where the substrate (200) is heated to a temperature of 250 degrees C or lower to form a first film containing the first element.

2. The method of processing the substrate (200) according to Claim 1, wherein (c) is performed at a temperature of 180 degrees C or higher and 220 degrees C or lower.

3. The method of processing the substrate (200) according to Claim 1, further comprising:
(d) supplying a third processing gas including the N-H bond and having a composition different from a composition of the second processing gas to the substrate; and
(e) performing (a) and (d) Y times, Y being a natural number, after (c) to form a second film containing the first element on the first film.

4. The method of processing the substrate (200) according to Claim 2, further comprising:
(d) supplying a third processing gas including the N-H bond and having a composition different from a composition of the second processing gas to the substrate; and
(e) performing (a) and (d) Y times, Y being a natural number, after (c) to form a second film containing the first element on the first film.

5. The method of processing the substrate (200) according to any one of Claims 1 to 3, further comprising (f) heat-treating the substrate at a temperature higher than the temperature of (c) after (c).

6. The method of processing the substrate (200) according to Claim 1, further comprising (f) heat-treating the substrate at a temperature higher than the temperature of (c) after (c),
wherein a third processing gas including the N-H bond and having a composition different from a composition of the second processing gas is supplied to the substrate during temperature rise to the higher temperature.

7. The method of processing the substrate according to Claim 2, further comprising (f) heat-treating the substrate at a temperature higher than the temperature of (c) after (c),
wherein a third processing gas including the N-H bond and having a composition different from a composition of the second processing gas is supplied to the substrate during temperature rise to the higher temperature.

8. The method of processing the substrate (200) according to Claim 3, further comprising (f) heat-treating the substrate at a temperature higher than the temperature of (c) after (c),
wherein the third processing gas including the N-H bond and having the composition different from the composition of the second processing gas is supplied to the substrate during temperature rise to the higher temperature.

9. The method of processing the substrate (200) according to any one of Claims 1 and 2, wherein in (b), a third processing gas including the N-H bond and having a composition different from a composition of the second processing gas is supplied.

10. The method of processing the substrate (200) according to Claim 1, further comprising (g) supplying a fourth processing gas containing a second element different from the first element during (a) and in at least one step after (a).

11. The method of processing the substrate (200) according to Claim 1, further comprising (h) supplying a fourth processing gas containing a second element different from the first element after (c) to form a film containing the second element on the first film.

12. The method of processing the substrate (200) according to Claim 1, wherein (b) is performed before (c).

13. A method of manufacturing a semiconductor device, comprising the method according to Claim 1.

14. A program that causes, by a computer, a substrate processing apparatus (10) to perform:
(a) supplying a first processing gas containing a first element and a halogen to a substrate (200);
(b) supplying a second processing gas including a N-N bond and a N-H bond to the substrate (200); and
(c) performing (a) and (b) X times, X being a natural number, while the substrate (200) is heated to a temperature of 250 degrees C or lower to form a first film containing the first element.

15. A substrate processing apparatus (10) comprising:
a first processing gas supply system (310, 312, 314) that supplies a first processing gas containing a first element and a halogen to a substrate (200);
a second processing gas supply system (320, 322, 324) that supplies a second processing gas including a N-N bond and a N-H bond to the substrate (200);
a heating system (207) that heats the substrate (200); and
a controller (121) capable of controlling the first processing gas supply system (310, 312, 314), the second processing gas supply system (320, 322, 324), and the heating system (207) so as to perform:
(a) supplying the first processing gas to the substrate (200);
(b) supplying the second processing gas to the substrate (200); and
(c) performing (a) and (b) X times, X being a natural number, while the substrate (200) is heated to a temperature of 250 degrees C or lower to form a first film containing the first element on the substrate (200).
